# EUROPEAN PATENT SPECIFICATION

(11) **EP 3 867 652 B1**
(45) Date of publication and mention of the grant of the patent: **08.03.2023**
(21) Application number: 19794098.4
(22) Date of filing: 14.10.2019
(51) Int. Cl.: G01R 19/25, G01R 25/00

(54) **ARCHITECTURE OF TIME SAMPLING DIGITAL SIGNAL PROCESSING DEVICE BASED ON AN APPLICATION OF THE FREQUENCY MULTIPLYING DEVICE**
ARCHITEKTUR EINER DIGITALEN ZEITABTASTENDEN SIGNALVERARBEITUNGSVORRICHTUNG AUF DER BASIS EINER ANWENDUNG DES FREQUENZVERVIELFACHERS
ARCHITECTURE DE DISPOSITIF DE TRAITEMENT DE SIGNAL NUMÉRIQUE À ÉCHANTILLONNAGE TEMPOREL EN FONCTION D'UNE APPLICATION DU DISPOSITIF DE MULTIPLICATION DE FRÉQUENCE

(30) Priority: 16.10.2018 EP 18200733
(43) Date of publication of application: 25.08.2021
(73) Proprietor: Smart Grid Solutions GmbH, 60594 Frankfurt am Main (DE)
(72) Inventor: ANTIC, Boris, 21000 Novi Sad (RS); SANTRAC, Branislav, 21000 Novi Sad (RS)
(74) Representative: König Szynka Tilmann von Renesse Patentanwälte Partnerschaft mbB Düsseldorf
(86) International application number: PCT/EP2019/077822
(87) International publication number: WO 2020/078927

(56) References cited:
- DE-A1- 3 205 296
- GB-A- 2 052 815
- US-A- 3 970 954
- US-A1- 2007 080 724
- US-A1- 2008 218 153
- Van Yang: "Coherent Sampling Solution for an Electric Power System", , 31 December 2012 (2012-12-31), pages 1-9, XP055654772, Retrieved from the Internet: URL:https://e2echina.ti.com/cfs-file/__key /telligent-evolution-components-attachment s/13-109-00-00-00-00-77-10/Electric-Power- System-Coherent-Sampling.pdf [retrieved on 2020-01-03]

## Description

The invention relates to the application of the Frequency Multiplying Device (FMD) - as described in PCT/EP2018/059421[1] - in the design of an arbitrary signal processing circuit, which uses time samples of a periodic signal to determine the properties of that signal.

The invention relates in general to the field of analogue to digital converters (ADCs), signal processing and spectrum analysis. The invention can be used as part of a measurement device or any signal processing device dealing with periodic signals.

Typically, devices used to calculate various statistical and/or spectral properties of the signal are sensitive to small errors in synchronization of the device with that signal. If the ratio of the sampling frequency and the signal's fundamental frequency (frequency corresponding to the inverse of the signal's period) is not an integer number and isn't constant over long periods of observation, the device and the signal are said to be "out of synchronization" of "unsynchronized" and the spectrum calculated from time samples will be distorted or the determined statistical properties will be erroneous. Unsynchronized signal processing results in leakage (shifting of energy between spectral amplitude components and occurrence of non-existing components in the spectrum), bias (additional energy component at 0 Hz) and phase shifting (distortion of the spectral phase distribution) as discussed in [2] and [3]. The correct spectrum reconstruction of a periodic signal from its digitized time samples is a well know issue in signal processing theory. Any processing of such spectrum will result in flawed characterization of the signal.

Statistical properties of periodic signals, such as amplitude, phase, median, root-meansquare (RMS), total harmonic distortion (THD) etc. are also very sensitive to incorrect synchronization and will accumulate error over prolonged time of observation as shown in [4].

These issues occur because majority of device manufacturers opt to construct a device with a fixed internal clock reference, also used for signal sampling. Commonly the signal's period is considered well-known in advance and the device takes that fact into account when setting the start and the end of the observation interval. However in reality due to various reasons, even the signals which are supposed to be very stable, e.g. power grid frequency, exhibit small drifts and variations over short periods of time.

One possibility to partially overcome this issue is to measure over extremely long periods of time compared to the duration of the signal's period and then average out the error of spectrum leakage. However, this approach incorrectly assumes that the frequency drift will be balanced in both directions (increase and decrease). If that is not the case, than the extension of the observation time will not be able to mitigate the problem. Furthermore, it will perform even worse in terms of error accumulation. The reason why it will perform worse is assumed to be that the end phase of the measurement interval will have a value that will solely depend on the amount of frequency shift, which can be considered random.

In some cases an alternative solution can be found in locking the device to the actual fundamental frequency of the signal by means of phase-locked-loop (PLL) circuit. However, this is valid only if the signal frequency exhibits a constant frequency variation over a short period of time, but not in cases when the frequency changes slightly over each consecutive period (strong phase noise present). The PLL output is always randomly shifted in time compared to the original signal, which makes it extremely inconvenient for sampling between two consecutive zero-crossings. Additionally, the PLL can't ensure extreme frequency ratios, necessary for modern devices operating in THz ranges.

Further possibilities include adaptive signal windowing, e.g. [5] and [6] and various signal post-processing algorithms, e.g. [7] and [8] to compensate for spectrum leakage. But their application is limited to very specific applications. Both approaches commonly assume very special signal features and properties, which is either not correct or significantly limits their application.

In the architecture of most widely used integrated harmonic measuring circuits today, the synchronisation with the input signal is commonly omitted, which is evident from the schematics indicating no clock reference, meaning that the entire circuit is triggered with a predefined clock rate and is thus "blind" for any frequency drifts at the input [11], [12], [13].

If, however, the ADC unit of the device is synchronized with any of the above mentioned methods, with all their drawbacks, it was additionally found necessary to use an asynchronous Random Access Memory (RAM) with dual ports operating at different rates. This further introduces the problem of accurately tracking the latest measurement data to be fetched by the signal processing unit of the measuring device [14], [15], [16].

Coherent signal sampling using ADC's synchronized to the signal period are known from the 2012 Texas Instruments Application Report SLAA570 "Coherent Sampling Solution for an Electric Power System" [17]; and from US2008/218153 [18].

Given this background, the problem to be solved by the invention is to improve signal processing and/or signal analyzing with regard to at least one of the afore-mentioned issues, especially to improve a device, a use and/or a method for signal processing, preferably in one aspect of the invention with an efficient synchronization with the input signal by fine-tuning the sampling frequency and by precisely aligning the start and stop instants in signal sampling with the signal's actual zero-crossings. This can in one aspect maintain a constant (arbitrary) integer number of samples taken from each signal period over large observation / measurement periods. Furthermore, since the signal's period is not considered to be known in advance, one aspect of the problem is also to ensure the information on the estimated value of the signal's fundamental frequency with an arbitrary small error, which can be used to correctly interpret the results of the signal processing and, where required, properly reconstruct the signal in an analogue form again.

This problem is at least partially solved by the subject matter of independent claim 1.

Preferred embodiments are described in the dependent claims and in the description following hereafter.

The concept proposed in the invention is to base the design of the signal processing devices, or modify the architecture of existing devices, where construction permits, by incorporating especially the FMD described in PCT/EP2018/059421 and by using its three outputs.

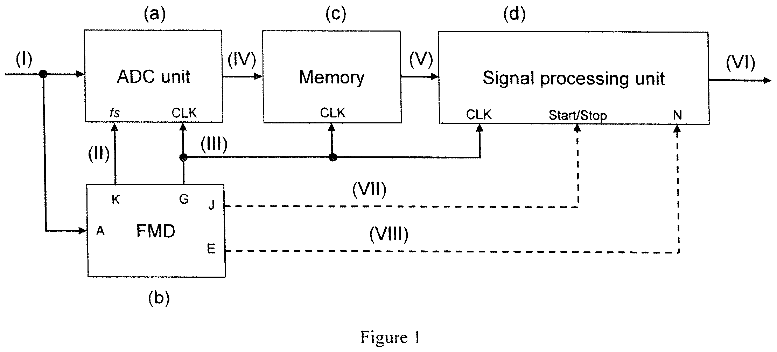

One embodiment of the invention is shown in Fig. 1.

According to a further (additional and/or alternative) aspect, the invention may solve an additional and/or alternative problem in circuit design and operation - an alignment of operation of the analogue part of the circuit (ADC unit) which is tuned to the fundamental frequency of the quantity to be measured and the digital part of the circuit (Signal processing unit) without the need to introduce the memory with asynchronous ports for read and write operations. Instead, a much simpler and faster RAM memory can be used with a deterministic synchronous sequential access, i.e. for each new stored measurement value provided by the ADC unit, the signal processing unit is capable of fetching that value at the subsequent clock interval. Especially, the output(s) of the ADC unit can be connected via the RAM memory to input(s) of the Signal processing unit. Thus, according to a preferred embodiment the memory is a RAM memory adapted to have synchronous ports for read and write operation.

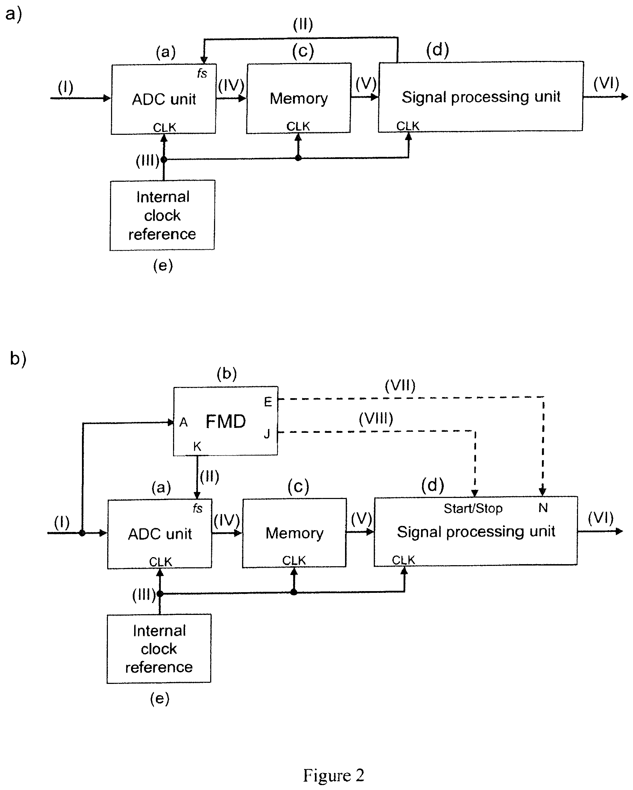

In case of the modification of an existing device the invention is to be applied as denoted in Fig. 2. In Fig. 2a) is depicted original generic block diagram of the device, while Fig 2b) denotes the rewired circuitry incorporating the FMD, which bypasses the sampling reference provided by the signal processing unit of the original circuitry. Alternatively, the internal clock reference can be completely omitted, providing the schematic identical to that in Fig. 1. However, even when considering the embodiment of Fig. 1, a separate clock reference to the Frequency Multiplying Device can be present but is assumed to be not necessary.

Since the analogue part (ADC unit) and the digital part (Signal processing unit) of the circuits are implemented on the same surface, but they are required to operate at different clock rates in this case it is necessary to introduce an asynchronous dual-port RAM.

According to one embodiment of the invention, two digital feeds or digital outputs of the Frequency multiplying device are provided to the Signal processing unit: 1) the start/stop pulse indicating an appropriate time corresponding to the actual duration of the signal period of the analogue signal which is to be processed, measured and/or analyzed and 2) the integer N representing the rounded up ratio of the internal clock frequency and the fundamental frequency of the analogue signal which is to be processed, measured and/or analyzed. Having these inputs considered by the Signal processing unit, the Signal processing unit doesn't need to assume a default value of the fundamental frequency nor the default positions of spectral components, but is capable to reconstruct the actual spectrum and position it precisely on the frequency axis, as well as to adequately calculate the total harmonic distortion (TDH) factor.

According to the invention, for the first time, it is considered to tune an entire circuit to the fundamental frequency of the analogue signal which is to be processed, measured and/or analyzed. An entire signal processing can be performed within the interval of the period of the analogue signal, especially regardless of how stretched that interval may be due to the input frequency drift. For the first time, the inventors have introduced a start/stop signal and a signal corresponding to the frequency estimate. These signals are not trivial to consider and the connection of the devices/units is one of the findings of the inventors to appropriately process the signals, especially the digitized signals. The start/stop signal and the estimate frequency signal enable automatic adjustment of the measurement/processing/analyzing interval and a straightforward calculation of spectral components because the number of samples per interval is maintained constant and strictly ten to the power of an integer number. This is important so that the ratio of the sampling frequency and fundamental frequency of the input signal remain an integer number as only division by ten is performed and in most applications this would lead to a constant number of samples per period. For example in case of a ratio which would be a power of 2, which would have been much easier to realize in digital technology, the division with such number would never lead to integers. The constant and known number of samples per each period can prevent occurrence of spectral leakage and inter-harmonic distortion during both measuring/analyzing and numerical processing of data by appropriate operation of the Signal processing unit in coherence with the ADC unit.

Benefits of at least one of the embodiments or aspects of the present invention can be: simpler hardware components, no timing skew between analogue and digital parts of the device/circuit allowing a normal/synchronous circuit/device design style, synchronous data flow without the need for dual port RAMs and/or constant and preprogrammable number of samples taken at the input within measurement/analyzing/processing interval.

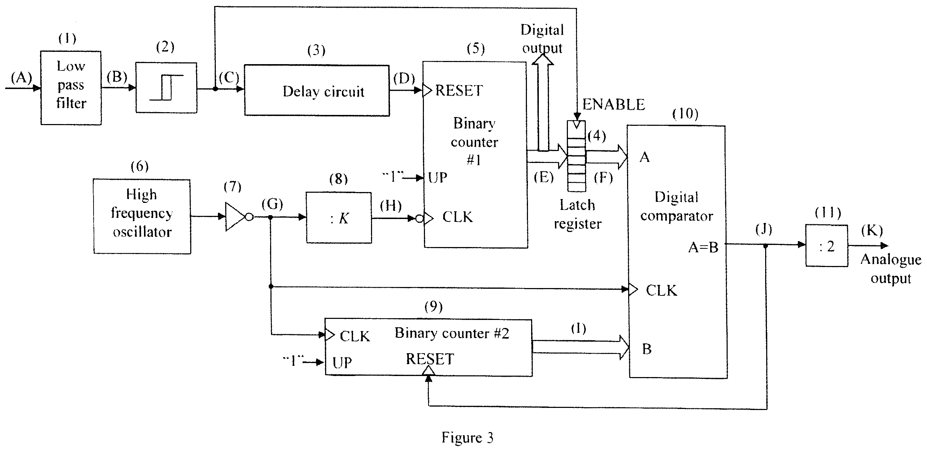

Finally, in reference to [1], the schematics of the FMD circuit is shown in Fig 3.

Advantages of the invention are listed in the following. The main advantage can be given by the fact that the device conforming the design principle of the invention will be adaptable to the input signals fundamental frequency in terms of the sampling rate, and observation's start and stop instants. Any processing performed in such device will be free from spectrum leakage pitfalls or severe measurement error accumulation.

The signal processing unit can apply Fourier transform DFT or FFT without compromising the validity of the measurement data. When input signals are periodic, there is no need for window-filtering to compensate for the distortions in the spectrum. The values of mean, RMS and higher statistical momentums are calculated exactly according to their definition.

Increase of the sampling frequency will increase the signal-to-noise ratio (reduce the quantization error) in a much wider range of oversampling rates since it will not affect the quality of the obtained samples.

Device designers are free from considering possible drifts and instability in the input signal since there is no need for any time consuming and resource demanding signal post-processing to reduce the errors, such as close-in noise of phase noise, caused by an inappropriate design in the analogue part of the circuitry.

Consequently, this opens up a variety of applications for considerably fast and precise analogue to digital conversion that could have not thought of before. For instance the majority of digital signal processing devices and instruments based on signal sampling, and particularly those that deal with periodic signals, require precise synchronization and constant integer number of samples per period. The invention can also be suitable in precise measurement of statistical properties of multiple signals, such as precise measurements of active, reactive and apparent power in power grids, phase angles between two signals, measuring auto-correlation and cross-correlation values.

The FMD described in PCT/EP2018/059421 also has a possibility to modify the ratio to a desired integer value by setting an arbitrary integer factor of the frequency divider denoted with (8) in Fig 3.

The described invention can be used in any measurement and/or signal processing device. It can be thought of applying the corresponding measurement device for detection of the frequency for power quality analysis applications or electricity metering in a power grid.

The term "input signal" in the description encompasses any signal, whose properties are to be characterized and brought to the input port of the device.

The term "analogue-to-digital converter unit" in the description comprise analogue and digital circuitry necessary to sample, hold, quantize and code the input signal into a digital, preferably binary form.

The term "Frequency Multiplying Device" refers to the circuit described in [1], which comprises an internal frequency reference, a series of frequency dividers, two binary counters and a digital comparator to generate a clock signal proportional to the exact multiple of the input signal's fundamental frequency. It also provides additional outputs which are used to obtain start and stop instants and the estimate of the fundamental frequency in a digital (binary) form.

The notion "internal clock reference" encompasses a clock generator or a circuit which is especially capable of producing a timing signal. Especially, the signal can be a rectangular, square or sinusoidal wave. The clock can be adapted as or comprising a frequency generator or oscillator that preferably has a high temporal stability. The signal generated by the clock can be a periodic or a non-periodic signal. The term clock encompasses as well an electronic circuit which receives an (external) signal which is a timing signal and processes the signal to generate a (further) timing signal, for example a frequency divider.

The notion "frequency divider" usually comprises an electronic device that can receive electric signals, optionally store them and preferably perform changes on said electric signal, typically in form of numerical operations. The received signal, that is typically changed, is then transferred to an output that can preferably allow different signal transmission standards. In a special embodiment, the adder-based shift register performs a numerical processing of the received values by averaging out code words of two preferably subsequent conversion phases, realized by shifting the converted value one bit to the right and adding this value to its previous content.

The notion "memory" usually comprises semiconductor electronic devices on an integrated circuits used to store digitized data in binary form.

The notion "signal processing unit" usually comprises a number of integrated circuits, enclosed in a single module (package) with its architecture optimized for the operational needs of digital signal processing. It may or may not comprise additional internal memory units.

The term "device" according to the description encompasses units and devices which can be connected forming a circuit.

Every electrical component referred to in this description can comprise an impedance, which means a complex resistance that can cause a change of amplitude and phase. In the same way, each electrical component can comprise not only a linear, but also a non-linear behavior. Non-linear in the context of electrical components or elements means, that, for instance, new frequencies are generated that were not available in the input signal of the specific electrical component before.

The embodiment shown in Fig. 1 comprises the ADC unit performing time and amplitude discretization of the input signal (I).

The input signal is fed to the ADC unit, which is connected to the FMD to obtain the clock reference signal and the sampling frequency signal via separate links and to the device memory to store the obtained samples in the digital form.

The input signal is also fed to the FMD, which is also connected to the memory circuit and signal processing unit to provide them with the clock signal. Additionally, the FMD can be connected to the signal processing unit via two additional link. One analogue to provide the start/stop instances coinciding with the input signal's zero crossings. And one digital to provide with the measured/estimated value of the signal's actual fundamental frequency necessary to interpret the result contained in the memory block.

Preferably, memory is connected to the signal processing unit via a separate bus to enable fetching the digitized values.
- Fig. 1: shows a block diagram of a signal processing device, where 1.a) denotes a generic schematic of arbitrary signal processing device and 1.b) denotes the device schematic after the modification with the invention
- Fig. 2: shows a block diagram of a signal processing device, where 1.a) denotes a generic schematic of arbitrary signal processing device and 1.b) denotes the device schematic after the modification with the invention
- Fig. 3: shows a block diagram of the Frequency Multiplying Device as described in [1].

Figure 1 shows the block diagram of an embodiment for a proposed architecture based on FMD implementation to ensure the sampling frequency independently from the device clock frequency. The analogue input signal (I) is connected both to the input (A) of the FMD (b) and to the input of the ADC unit (a). The FMD uses (I) to extract and multiply its fundamental frequency. The ADC unit performs discretization of the input signal in time and the quantization of its amplitude to provide the digital representation of that signal. The first analogue output (K) of the FMD (b) is connected to the input (fs) of the ADC unit (a) providing the sampling frequency clock signal (II) which is the integer multiple of the fundamental frequency of the input signal, ensuring that the number of samples taken in each period is constant and known.

The second analogue output (G) of the FDM (b) further connects to (CLK) inputs of (a), (c) and (d) proving the high frequency clock signal (III) for the entire device. The third analogue output (J) of the FMD (b) connects to the analogue input (start/stop) of (d) to provide pulse indication (VII) of the zero crossings of the input signal (I). This signal can be used for additional control over the AD conversion process such as indication that information is ready. Although it can be omitted since the number of samples to be fetched from memory (c) is known in advance. The signal (VII) can be called start/stop signal.

The fourth digital output (E) of the FMD (b) connects to the digital input (N) of (d) to transmit the information on measured/estimated fundamental frequency on form of digits (VIII). This information is essential for the proper interpretation of the measurement results since it the only indication of the actual scale of the signal's spectrum on the frequency axis. In case only statistical parameters of the input signal are required, this output may not be necessary since this statistical moments are averaged over a finite number of exact period intervals. The signal (VIII) can be called frequency estimate or fundamental frequency estimate.

The digital output of the ADC circuit (a) connects to the digital input of (c) to transmit digital (binary) sequence (IV), which is the digital representation of the input signal (I). This is a continuing stream of digital values as long as the AD conversion process is enabled.

The digital output of the Memory block (c) connects to the digital input of (d) to enable fetching the digitized values (V) for further processing. The data flow of (V) is independent and asynchronous from that of (IV) between blocks (a) and (c). The rate of (V) corresponds to the maximum speed of data rate over device's bus determined by the operating clock signal (III), while the rate of (IV) is determined by the value of (II).

The Signal processing unit (d) uses (V), (VII) and (VIII) to perform the desired computation and processing of digitized values and report it using its digital output (VI). The digital output of (d) denoted with (VI) should also comprise the information contained in (VIII).

Figure 2 illustrates one possible transition from a conventional generic architecture of the signal processing device to the configuration of this invention.

In Fig 2a) the input signal (I) is fed only to the input of the ADC unit (a). The internal clock reference (e) provides the operating clock (III) for all modules of the device. The ADC unit feeds the Memory block with digitized values of (I), wherefrom they are fetch on demand by the Signal processing unit similar to the already explained schematic provided in Fig. 1. The main difference is that the sampling frequency is determined by the Signal processing unit or it can be internally fixed by the design of the ADC unit depending on the application of the device.

The transition to the schematics shown in Fig. 2b) is achieved by disconnecting the Signal processing unit (d) from the ADC unit's (a) input fs and by inserting the FMD (b) to provide for signal (II) instead. To ensure the functionality of the FMD, the input signal should be connected to its analogue input A, from which it will perform the fundamental frequency extraction and multiplication. Additionally, the FMD can be connected from its analogue output (J) back to (d) to provide the information about zero crossings of the input signal as indication on the instances at which the conversion is completed and the entire measurement data is ready for further processing, as well as the from its digital output (E) to provide an integer number proportional to the actual ratio of the reference signal clock and the fundamental frequency of the input signal (I). The connection of both these outputs is optional when only scalar values characterizing the input signal (I) are required. However if more complex information is required at the output (VI) such as spectral components or a stream of all processed signal samples, then the feed of (VIII) to the (d) is mandatory. Otherwise the stream of digital values at (VI) would have an infinite number of possible interpretations.

Fig. 3 is an excerpt from [1] where it is explained in detail.

### Reference signs used in Figs. 1 to 3:

(I) input signal
(II) sampling clock
(III) device circuitry operating clock
(IV) digitized samples of the input signal
(V) digitized samples fetched for digital processing
(VI) output of the device
(VII) analogue pulse signal indicating start/stop instances for signal processing synchronization
(VIII) digital value of the ratio of the sampling frequency and the fundamental frequency of the input signal
(CLK) clock input of a digital part of the circuitry
(fs) sampling frequency input
(a) ADC unit
(b) Frequency Multiplying Device
(c) Memory
(d) Signal processing unit
(e) Internal clock reference

The following annotations and legend is taken over from [1]:
(A) analogue input of the FMD (input signal)
(E) digital output of the FMD (ratio of the sampling rate and the fundamental frequency of the input signal)
(G) analogue pulse output of the FMD (referent frequency clock signal)
(J) analogue pulse output of the FMD (start/stop signals)
(K) analogue pulse signal whose frequency is the desired multiple of the fundamental frequency of the input signal.

In the following a frequency multiplying device is described which can be used with regard to the present invention and which is explained in [1].

The general concept of the frequency multiplying device is to generate a reference signal with a frequency f_{osc} and generate a further reference signal having a frequency f_{K}. The multiplication is independent from the reference signal but dependent from the ratio of the reference signal and the further reference signal. When providing the reference signal and the further reference signal substantially from the same source, a constant and/or pre-determined multiplication factor can be obtained. The frequencies of the reference signal and of the further reference signal doesn't have to be considered on their own. The inventors have for the first time realized that a counting of edges of a signal having a frequency f_{osc}/K during a period of the target signal and counting the edges of a signal having a frequency f_{osc} can obtain a signal having a multiple of the frequency of the target signal when comparing the two results and outputting a signal in case that the two counts are the same. Thus, even without knowing the frequencies of the reference signal and the further reference signal the multiplication of the frequency of the target signal will be of high accuracy, especially in case the reference signal is stable.

For the frequency multiplying device a simple hardware can be used which can be also implemented as a part of an integrated circuit. The frequency multiplying device allows for a device, where there is no substantial delay in information propagation from the input to the output allowing fast reactions. If the fundamental frequency changes from cycle to cycle, the measurement ends precisely at the end of the signals period. Another advantage is that the information on the frequency ratio is available in digital form. Further, the multiplication factor is arbitrarily high and is preferably in the range of approximately 2 to 10⁵. The increase in multiplication factor does not require an increase in complexity of the hardware. Another benefit of the frequency multiplying device is that it allows the generation of a digital signal with for instance 50/50% filling factor with significant power to trigger outside circuitry.

This opens up a variety of new applications for highly precise measurement of a fundamental frequency since higher frequencies often allow lower errors of preferably less costly hardware for e.g. digitisation and/or frequency determination. By changing an input filter and/or by changing a division factor K of a frequency divider that is preferably integrated in the proposed circuit, the circuit can also be applied in any instrument measuring harmonics such as in EMC testers and RF immunity testing on demand, or for evaluating harmonics in aircraft equipment in which the fundamental frequency may easily change to other harmonics. Alternatively, such instruments can be used to observe changes in the harmonic distortion factor in each phase of semiconductor components and non-linear input elements. In audio analyzers the invention can be applied for determining the distortion factor of audio signals since this typically requires an exact determination of the fundamental frequency, but the invention can also be utilised in frequency multiplexers and demultiplexers when significant signal dispersion is expected.

The signal generated by the proposed frequency multiplying device is suitable for determination of the fundamental frequency f of the analogue target signal.

The elements of the frequency multiplying device can be integrated circuits, especially the elements specified in the description are separate integrated circuits forming a larger circuit. Preferably, the elements specified in the description can be identified in the integrated circuit as such.

The notion "coupled" denotes an electrical connection between two elements which may be a direct connection, but can also comprise further active or passive electric or electronic elements for adapting and optimizing an electrical signal between the two elements (indirect connection).

The term "generating device" encompasses a frequency generator or oscillator or clock that preferably has a high temporal stability. The "generating device" can provide a stable reference signal, including periodic and partly non-periodic signals, especially with regard to amplitude.

Furthermore, the term "frequency divider" refers to an electronic device which is adapted to divide the frequency of an input signal by a factor K, wherein K is an integer, but K can - in general - also comprise a real or complex number in particular when an electric component also generates a phase shift that can be incorporated in an imaginary part of a number. It also has to be considered that every electrical component referred to in this description can comprise an impedance, which means a complex resistance that can cause a change of amplitude and phase. In the same way, each electrical component can comprise not only a linear, but also a non-linear behavior. Non-linear in the context of electrical components or elements denotes, that for instance new frequencies are generated that were not available in the input signal of the specific electrical component before.

The term "counter" encompasses an electronic device which is adapted to count events in a signal, especially rising or falling edges. A counter can be a binary or digital counter. A binary counter can be constructed by a number of flip-flops connected in cascade. A binary or digital counter can be a common integrated circuit having a "RESET" (reset) input, a "UP" input, a "CLK" (clock) input and an output.

The term "comparator" encompasses an electronic device which is adapted to compare two inputs. A comparator can be a common integrated circuit having two inputs "A" and "B" as well as a "CLK" (clock) input and an output. The term comparator encompasses a digital or binary comparator.

The term "correspond" in the entire description of the patent comprises the meaning of "relate" and/or "substantially equal" and/or "substantially proportional".

In the description, the term "trigger" encompasses an integrated circuit which is adapted to extract the fundamental frequency of an input signal. The term "trigger" encompasses a Schmitt trigger or any other kind of trigger circuit. Further, the term "trigger" can encompass that input signal is previously, simultaneously or subsequently filtered, especially low pass filtered.

In a preferred embodiment, the frequency determining multiplying device for determining a fundamental frequency f of an analogue target signal comprises at least a signal input (A) that is connected to a trigger- , which is subsequently connected to a first counter. The trigger converts said analogue input signal to a digital output signal (C). The circuit further comprises a generating device for generating a reference signal (G) having a frequency *f*_{osc} higher than the fundamental frequency f of the target signal. The reset input of the first counter is coupled to the trigger and the clock input of the first counter is coupled to the generating device. The output (E) of the counter can have a maximal decimal value N. Subsequent to the counter the output can be coupled to a first input A of the comparator, wherein a latch register can be coupled between the first counter and the comparator for receiving and storing the digital output (E) of the first binary counter. The frequency of the reference signal (G) is divided by K and the corresponding signal is received by the clock input of the first counter. Further, the reference signal (G) is received by the clock input of the comparator and by the clock input of the second counter, said second counter generates an output signal (I) and is coupled to a second input B of the comparator comparing the output (I) with the digital values (F) of the latch register coupled to the first input A of the comparator. Said comparator generates an analogue output signal (J) having a frequency that is a multiple of the fundamental frequency of the analogue input signal (A). Further the analogue output signal serves as a reset signal for the second counter.

Thus, the comparator can be provided in a negative reset loop. The comparator can be provided in a negative reset loop connected to the second counter to reset the second counter.

Preferably, the first and second counter have an edge-triggered "RESET" input. In an advantageous realization, both counters are set to logical "1" so that the counters always count up. The digital comparator preferably has an edge-triggered "CLK" input. The generating device provides a frequency that is usually significantly higher than the fundamental frequency that needs to be detected precisely. In a preferred embodiment, the reference signal generating device generates a highly stable frequency with a Q factor preferably lower or equal to 1 ppm and the temperature parabolic factor better than 0.1 ppm/°C².

Preferably, the edge triggered clock input of the first binary counter is inverted that may improve also the stability of the signal.

In a preferred embodiment, the frequency multiplying device has a latch register coupled to the output of the first counter. By this, the results of the counter can be stored and used with a time shift, especially when the values are required later. Furthermore, depending on the read and write method, values can also be amended or provided in other formats. The count of the first counter stored in the latch register can correspond to the ratio of two frequencies at inputs "CLK" and "RESET" and thus can represent the ratio of the frequency *f*_{osc} of the reference signal (G) and the fundamental frequency f given by *f*_{osc}/(*K·f*).

In a preferred embodiment the latch register is a latch and shift register. Thus, if a latch register is mentioned in the description it can also refer to a latch and shift register. By a latch and shift register the bits can be shifted to the right. The shifting will be explained below.

In a further preferred embodiment, the output of the first counter is divided by D1 before in particular led to the latch register. Preferably D1 is an integer power of 2. Preferably, this is achieved by shifting the bits log2(D1) places to the right, preferably by one place to the right in case D1 is equal to 2, or generally an integer power of 2. In other words, the MSB of the output of the first counter is coupled to the MSB-1 bit of the latch register. The MSB-1 bit of first counter is coupled to the MSB-2 bit of the latch register etc., until the LSB+1 bit of the first counter is coupled to the LSB of the latch register. The last LSB bit of the first counter is not coupled to the latch register. Alternatively, a division by 4, 8, 16, etc. is possible as the same method can be performed for other factors D1 that can be represented by 2", where n denotes a natural number.

In another preferred embodiment, the output of the comparator is coupled to a frequency divider with the factor D2, preferably dividing by a factor of D2=2, resulting in an analogue signal (K). Alternatively, a division by 4, 8, 16, etc. is possible as the same method can be performed for other factors that can be represented by 2", where n denotes a natural number. Preferably, the factor of the frequency divider corresponds to or is equal to the factor with that the output of the first counter (E) is changed, especially by the aforementioned method of shifting.

In a further preferred embodiment, the output of the reference signal module is coupled to an inverter. The inverter can be realized as an inverted amplifier. The inverter can stabilise the signal due to the typical characteristics of an amplifier circuit.

In another preferred embodiment, the signal (C) is delayed by a delay circuit generating the output signal (D) led to the reset input of the first counter. The delay assures that the latch register is free to receive the signal from the first counter and is typically much shorter than one measurement cycle.

In another preferred embodiment, the input signal (A) is filtered by a low pass filter before entering the trigger circuit in order to suppress higher unwanted harmonic frequencies as well as noise which may cause error in the measurement circuit. The corresponding cut-off frequency of the low pass filter usually corresponds to a lower frequency than the maximum frequency that measurement circuit can handle correctly. In a particularly preferred embodiment, the output signal (K) has a frequency that is a K-multiple of the fundamental frequency f. The signal (G) having the reference oscillator's frequency *f*_{osc} preferably drives the second counter which is counting up in particular at a much higher rate. Preferably whenever the output of the second counter and the latch register are equal (both are at *N*/2), the comparator generates a relatively short RESET signal (J) at its "A=B" output. This signal typically resets the second counter to zero and the counting of that counter will continue. Within one period of the input signal (A) the second counter will reset exactly 2*K* times because it corresponds to the ratio of frequencies *f*_{osc} and f/2 due to the division by 2 (right shifting) prior to coping the value into the latch register. The "A=B" output of the digital comparator is led to a frequency divider by factor 2 to obtain the signal (K) with 50/50% fill ratio. Signal (K) is the analogue output signal with the frequency of *K·f*.

A measurement device with a frequency multiplying device according to the description is described. The corresponding measurement device can be applied for example in EMC testers and RF immunity testing on demand, an application is in a generator to detect the shifting power grid frequency and synchronise its generated electricity to the grid frequency for injection, for precise measurement of consumed power in AC-grids, for evaluating harmonics in aircraft equipment in which the fundamental frequency easily changes to harmonics, in instruments used to observe changes in the harmonic distortion factor in each phase of semiconductor components and non-linear four input elements, in audio analysers determining the distortion factor of audio signals as well as in frequency multiplexers and demultiplexers when significant signal dispersion is expected. The measurement device can comprise a frequency determining device which is adapted to determine the frequency of the signal generated by the frequency multiplying device.

The frequency multiplying device also provides the use of a comparator for multiplying a fundamental frequency f of an analogue target, wherein a reference signal with a frequency f_{osc}, the frequency *f*_{osc} being higher than the frequency f, is generated and a further reference signal which is the reference signal having a frequency f_{K}, which is f_{osc}/K, is generated, and signal edges of a signal corresponding to the further reference signal during a time interval which relates to a period of the analogue target signal are counted, and signal edges of a signal corresponding to the reference signal are counted, the comparator is used to compare counting signals of the two counting steps, and is used to generate a signal which corresponds to the counting signals and used to reset the counting of the signal edges of the counting signal corresponding to the reference signal.

Furthermore, a method for multiplying a fundamental frequency f of an analogue target signal is described. The method comprises the steps of: generating a reference signal with a frequency f_{osc}, the frequency f_{osc} being higher than the frequency f and generating a further reference signal which is the reference signal having a frequency f_{K}, which is f_{osc}/K, counting signal edges of a signal corresponding to the further reference signal during a time interval which relates to a period of the analogue target signal, counting signal edges of a signal corresponding to the reference signal, generating counting signals of the two counting steps, and comparing the counts of the two counting steps, wherein a signal is generated which corresponds to the counting signals and output as a signal corresponding to the output signal and used to reset the counting of the signal edges of the counting signal corresponding to the reference signal.

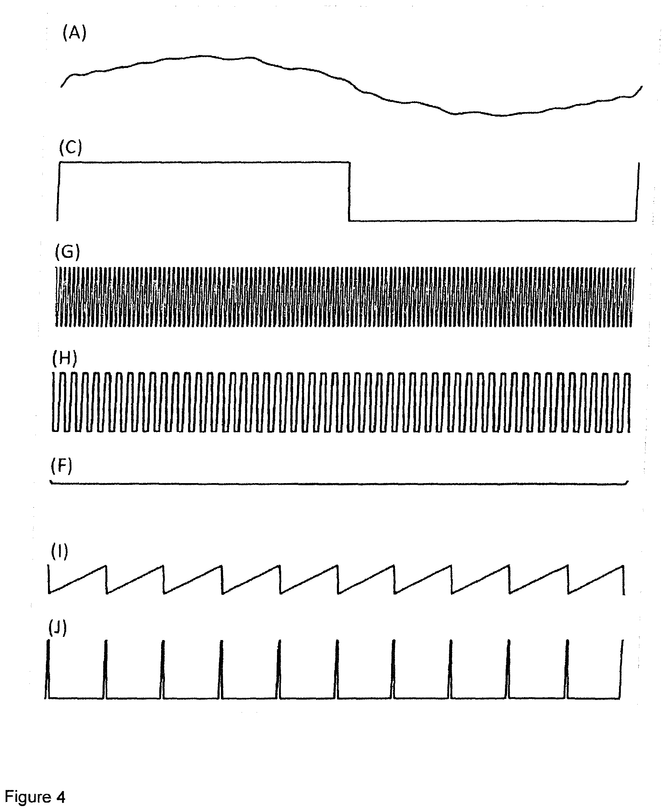

- Fig. 4: illustrates the signals related to the block diagram of fig. 3 and

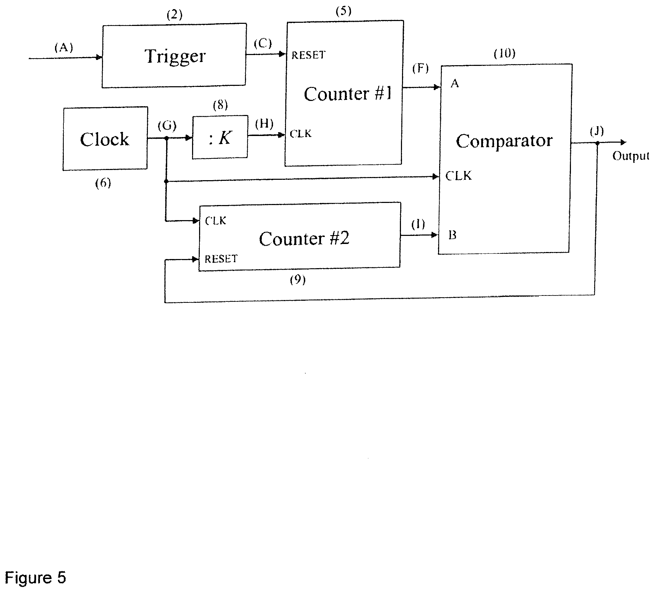

- Fig. 5: shows a block diagram of the frequency multiplying device in a simplified embodiment of fig. 3.

In fig. 3, an embodiment according to the invention is shown. An analogue input is fed into a low pass filter 1. The output of the filter 1 is coupled to the input of a Schmitt-trigger 2 or a comparator in general. The output of the Schmitt-trigger 2 is coupled to the input of a delay circuit 3 and the edge-triggered "ENABLE" input of a latch register 4. The delay circuit 3 is coupled to the edge-triggered "RESET" input of a first binary counter 5. The "UP" input of said first binary counter 5 is coupled to logical 1 so that counter 5 always counts up. The output of a high frequency oscillator 6 is coupled to the input of an inverter 7. The output of the inverter is fed into a frequency divider 8 (the factor of the frequency divider is K), and thereby to the edge-triggered "CLK" input of a digital comparator 10, and also to the edge-triggered "CLK" input of a second binary counter 9. The digital output of the first binary counter 5 can serve as a digital output of the circuit. The digital output of the first binary counter 5 is also fed into a latch register 4 by shifting the bits one place to the right, so that the MSB of the output of the first binary counter 5 is coupled to the MSB-1 bit of the latch register 4, whereby MSB denotes most significant bit. The MSB-1 bit of 5 is coupled to the MSB-2 bit of 4 and so on, until the LSB+1 bit of 5 is coupled to the LSB of 4, whereby LSB denotes least significant bit. The last LSB bit of the first binary counter 5 is not coupled to 4. The output of the frequency divider 8 is coupled to the inverted edge-triggered "CLK" input of the first binary counter 5. The digital output of 4 is coupled to the digital input "A" of the digital comparator 10 and the digital output of the second binary counter 9 is coupled to the digital input "B" of the digital comparator 10. The "A=B" output of the digital comparator 10 is coupled to the "RESET" input of the second binary counter 9 and to the input of a frequency divider 11 by 2. The output of the frequency divider 11 by 2 is the analogue output of the circuit and it generates the desired K multiple of the input signal.

Fig. 4 shows an illustration of the signals from figure 3. The circuit from figure 3 uses a high-frequency reference oscillator with the frequency *f*_{osc} and a frequency divider with the factor *K* to generate a *K* multiple frequency of an unknown fundamental frequency of the input signal A. The reference frequency and the multiplication factor have to be set in advance, but the principle of operation is independent on the choices of *f*_{osc} and *K.* The input signal A should be any periodic signal which fundamental frequency *f* is unknown. The circuit can provide two outputs: one digital output (E) corresponding to the ratio of the unknown frequency *f* and the frequency *f_{osc}*/*K* and one analogue output K - the digital clock signal having 50/50% fill ratio and the fundamental frequency equal to *K·f*.

The signal of the reference oscillator 6 is first inverted and by this preferably also stabilized by application of an inverter 7 and then led to a frequency division circuit 8 with the factor *K.* The signal H at the output of the frequency divider 8 is used to trigger counting of the first binary counter 5. The binary counter will count upward because its "UP" input is coupled to a logical "1", as long as the signal D passes through one period.

Signal D is obtained from the input signal A. First, the signal A with the unknown fundamental frequency *f* passes through a low-pass filter 1 to suppress noise and higher harmonics. The low-pass filter 1 produces signal B, which is then coupled to the input of a Schmitt-trigger circuit 2 to obtain square pulses C with frequency equal to *f.* This signal is used to enable the transfer of the output of first binary counter 5 into a latch register 4, where it is kept until the end of the cycle defined by the fundamental frequency *f.* A slightly delayed signal D is led to the RESET input of the first binary counter 5 to allow for a good synchronization with the latch register precisely at the end of the cycle. The delay should be shorter than the period of the signal H but longer than the speed of the latch register 4.

Besides latching, the output of the first binary counter 5 is divided by 2 before led to the latch register 4. This is achieved by shifting the bits one place to the right. In other words, the MSB of the output of 5 is coupled to the MSB-1 bit of the 4, The MSB-1 bit of 5 is coupled to the MSB-2 bit of 4 and so on, until the LSB+1 bit of 5 is coupled to the LSB of 4. The last LSB bit of the first binary counter 5 is not coupled to 4. Let integer number "N" denote the maximal decimal value of the first binary counter 5 at the moment of latching. *N* is the ratio of two frequencies at inputs "CLK" and "RESET" and equals *f_{osc}*/(*K·f*). Then the value copied into the latch register equals *N*/2 = *f_{osc}*/*(2K_{·}f).*

On the other hand, the signal G having the reference oscillator's frequency *f*_{osc} drives the second binary counter 9 which is counting up at a much higher rate. Whenever the output of the second binary counter 9 and the latch register 4 are equal (both are at *N*/2) the digital comparator 10 will generate a short RESET signal J at its "A=B" output. This signal will reset the second counter 9 to zero and the counting of that counter will continue. Within one period of the input signal A the second binary counter 9 will reset exactly 2*K* times because it corresponds to the ratio of frequencies *f*_{osc} and *f*/2 due to the division by 2 (right shifting) prior to coping the value into the latch register 4. The "A=B" output of the digital comparator 10 is led to a frequency divider by factor 2 to obtain the signal K with preferably 50/50% fill ratio. Signal K is the analogue output signal with the frequency of *K·f*.

Fig. 5 shows a block diagram of a simplified second embodiment of the frequency multiplying and/or determining device to illustrate the measurement method. Here, the Schmitt trigger 2 is replaced by a general trigger and the reference signal generating device is given by a general clock 6. The arrows indicate a coupling or transferring of signals, that also can comprise a change of the signals by other additional electrically active components.

### References:

[1] B. Antic, S. Santrac, "Frequency Multiplying Device", patent application PCT/EP2018/059421
[2] W. A. C. Perera, J. F. Chicharo, B. S. P. Perera, "On the merits and demerits of using a fast fourier transform approach for establishing the harmonic spectrum in power system", Proc. AUPEC '93, pp. 108-115, Sept. 29-Oct. 1 1993.
[3] A. A. Girgis, F. Ham, "A qualitative study of pitfalls in FFT", IEEE Trans. Aerosp. Electron. Syst., vol. AES-16, no. 4, pp. 434-439, July 1980.
[4] K. Srinivasan, "Errors in digital measurement of voltage active and reactive power and an on-line correction for frequency drift", IEEE Trans. Power Delivery, vol. PWRD-2, no. 1, pp. 72-76, Jan. 1987.
[5] G. Andria, "Windows and interpolation algorithms to improve electrical measurement accuracy", IEEE Trans. Instrum. Meas., vol. IM-38, pp. 856-863, Aug. 1989.
[6] Fredric J. Harris, "On the use of Windows for Harmonic Analysis with the Discrete Fourier Transform", Proceedings of the IEEE, V66N1, Jan. 1978, pp. 51-83.
[7] Fang Xu, "Algorithm to Remove Spectral Leakage, Close-in Noise, and Its Application to Converter Test", 2006 IEEE Instrumentation and Measurement Technology Conference Proceedings, Date of Conference: 24-27 April 2006 , Conference Location: Sorrento, Italy , Date Added to IEEE Xplore: 12 March 2007
[8] Dj. Haddadi, D. Dallet, Ph. Marchegay, "Phase noise compensation in ADC characterization by spectral analysis", IMTC 2005 - Instrumentation and Measurement Technology Conference, May 17-19, 2005.
[9] V. Vujicic, "Digital Instrument for Measuring Harmonics", patent YU 48640 B, 1996.
[10] V. Vujicic, S. Milovancev, "Digital Instrument for Measuring Mean Value of the Product of two Periodic Signals", patent YU 48195 B, 1995.
[11] Tl Designs, "Multi-Phase Power Quality Measurement With Isolated Shunt Sensors", Texas Instruments, Key System Specifications, http://www.ti.com/lit/ug/tidubo7a/tidubo7a.pdf, January 2016.
[12] Analogue Devices, "Energy Metering IC with Sensor Monitoring and Autocalibration", Data Sheet, https://www.analog.com/media/en/technicaldocumentation/data-sheets/ADE9153B.pdf, 2017.
[13] Sufyanu A, "Power Quality and Harmonic Analysis in Three Phase Systems", Journal of Electrical & Electronic Systems, Vol 7, Issue 4, 1000291, DOI: 10.4172/2332-0796.1000291, January 2018.
[14] Peng Fei, Meng Zhang, Shaofeng Yu, Qingqing Mu, Yibo Gao, Huixuan Shi, "An On-line Multiplexed High Accuracy Electric Energy Meter Based on Dual-access RAM", Proceedings of the 2016 Joint International Information Technology, Mechanical and Electronic Engineering (JIMEC 2016), October 4-5, 2016 in Xi'an, China, DOl: 10.2991/jimec-16.2016.19, January 2016.
[15] Byron Slater, Gordon Burns, John Voisine, "Electronic meter having random access memory with passive nonvolatility", patent No. US20020036492A1, 2001.
[16] Shouxi Zhu, Wenlai Ma, "A Design of Aircraft Grid Harmonic Detection Device using DSPandARM", International Journal of Control and Automation, Vol.8, No.3, pp.81-98, http://dx.doi.org/10.14257/ijca.2015.8.3.11, 2015.
[17] Texas Instruments Application Report SLAA570 "Coherent Sampling Solution for an Electric Power System", 2012.
[18] US2008/218153.

## Claims

1. A device comprising
a Frequency Multiplying Device (b),
an analog-digital conversion, ADC unit (a), and
a Signal processing unit (d),
wherein the Frequency Multiplying Device (b) has an input for an analogue signal (A) which is to be processed, measured and/or analyzed, wherein the Frequency Multiplying Device (b) is adapted to count edges of a signal having a frequency f_{OSC}/K during a period of the target signal and counting the edges of a signal having a frequency f_{OSC} to obtain a signal having a multiple of the frequency of the analogue signal (A) when comparing the two results and outputting a signal in case that the two counts are the same, and
the ADC unit (a) has an input for the analogue signal,
an output of the ADC unit (a) is connected to an input of the Signal processing unit (d),
wherein the ADC unit (a) and the Signal processing unit (d) are connected and adapted to be tuned to the fundamental frequency of the input signal (A) and to perform the Processing, Measurement and/or Analysis within the interval of the period of the input signal (A), wherein
the Frequency Multiplying Device (b) has at least two outputs (K, E):
- one of which is to provide the chosen multiple of the fundamental frequency (II) of the signal to be processed (A), wherein this output (K) is connected with an input (fs) of the ADC unit (a), and
- one of which is to provide for the actual ratio of frequencies (VIII) in a digital, preferably binary, form, and
the ADC unit (a) and the Signal processing unit (d) each have an input (CLK) for a clock signal (III) having the frequency f_{OSC}.

2. The device according to claim 1, wherein the Frequency Multiplying Device (b) has
a start/stop output (VII)
wherein the start/stop output (VII) and the output (E) providing the actual ratio of frequencies (VIII) are connected to inputs of the Signal processing unit (d).

3. The device according to claim 1 or 2, wherein the analogue-to-digital conversion unit (a) further comprising an output providing digitized values of the input signal.

4. The device according to claim 3, wherein the device comprises
- a memory (c) to store digitized values of the input signal received from the analogue-to-digital conversion unit (a), especially between conversion and processing phases with one clock input, one digital input and one digital output.

5. The device according to claim 4, wherein the memory (c) has all digital interfaces parallel in design.

6. The device according to any one of claim 1 to 5, wherein
- the signal processing unit (d) is adapted to fulfill the main processing functionality of the device, the signal processing unit (d) having a digital input for fetching external data.

7. The device according to claim 6, the signal processing unit (d) comprising a second analogue input (N) for obtaining frequency estimate information and/or a second digital output connected to additional internal memory capacity.

8. The device according to any one of claims 1 to 7, wherein the analogue-to-digital conversion unit (a) comprises a minimum of sample-and-hold circuit, quantizer and preferably a digital coder, capable of performing an analogue-to-digital conversion.

9. The device according to any one of claim 1 to 8, capable of performing frequency multiplication and reporting on the start and end instances of the AD conversion phase through it analogue output (J) coupled to the signal processing unit (d), and capable of reporting on the estimated value of the fundamental frequency through its digital, preferably binary output (E) also coupled to the signal processing unit (d).

## Patentansprüche

1. Vorrichtung, umfassend:
eine Frequenzmultiplikationsvorrichtung (b),
eine Einheit eines Analog-Digital-Wandlers (ADC) (a), und
eine Signalverarbeitungseinheit (d),
wobei die Frequenzmultiplikationsvorrichtung (b) einen Eingang für ein analoges Signal (A) aufweist, das verarbeitet, gemessen und/oder analysiert werden soll, wobei die Frequenzmultiplikationsvorrichtung (b) angepasst ist, um Flanken eines Signals, das eine Frequenz f_{OSC}/K aufweist, während einer Periode des Zielsignals zu zählen und die Flanken eines Signals, das eine Frequenz f_{OSC} aufweist, zu zählen, um ein Signal zu erlangen, das ein Vielfaches der Frequenz des analogen Signals (A) aufweist, wenn die zwei Resultate verglichen werden, und ein Signal in dem Fall auszugeben, dass die zwei Zählungen gleich sind, und
wobei die ADC-Einheit (a) einen Eingang für das Analogsignal aufweist,
ein Ausgang der ADC-Einheit (a) mit einem Eingang der Signalverarbeitungseinheit (d) verbunden ist,
wobei die ADC-Einheit (a) und die Signalverarbeitungseinheit (d) verbunden und angepasst sind, um auf die Grundfrequenz des Eingangssignals (A) abgestimmt zu werden und das Verarbeiten, Messen und/oder Analysieren innerhalb des Intervalls der Periode des Eingangssignals (A) auszuführen, wobei
die Frequenzmultiplikationsvorrichtung (b) mindestens zwei Ausgänge (K, E) aufweist:
- wovon einer dazu dient, das gewählte Vielfache der Grundfrequenz (II) des zu verarbeitenden Signals (A) bereitzustellen, wobei dieser Ausgang (K) mit einem Eingang (fs) der ADC-Einheit (a) verbunden ist, und
- wovon einer dazu dient, das tatsächliche Verhältnis der Frequenzen (VIII) in digitaler, vorzugsweise binärer, Form bereitzustellen, und
die ADC-Einheit (a) und die Signalverarbeitungseinheit (d) jeweils einen Eingang (CLK) für ein Taktsignal (III) aufweisen, das die Frequenz f_{OSC} aufweist.

2. Vorrichtung nach Anspruch 1, wobei die Frequenzmultiplikationsvorrichtung (b) einen Start/Stopp-Ausgang (VII) aufweist, wobei der Start/Stopp-Ausgang (VII) und der Ausgang (E), der das tatsächliche Verhältnis der Frequenzen (VIII) bereitstellt, mit Eingängen der Signalverarbeitungseinheit (d) verbunden sind.

3. Vorrichtung nach Anspruch 1 oder 2, wobei die Analog-Digital-Wandlereinheit (a) ferner einen Ausgang umfasst, der digitalisierte Werte des Eingangssignals bereitstellt.

4. Vorrichtung nach Anspruch 3, wobei die Vorrichtung Folgendes umfasst
- einen Speicher (c) zum Speichern digitalisierter Werte des von der Analog-Digital-Wandlereinheit (a) empfangenen Eingangssignals, insbesondere zwischen Wandlungs- und Verarbeitungsphasen mit einem Takteingang, einem digitalen Eingang und einem digitalen Ausgang.

5. Vorrichtung nach Anspruch 4, wobei der Speicher (c) alle digitalen Schnittstellen in paralleler Konstruktion aufweist.

6. Vorrichtung nach einem der Ansprüche 1 bis 5, wobei
- die Signalverarbeitungseinheit (d) angepasst ist, um die Hauptverarbeitungsfunktionen der Vorrichtung zu erfüllen, wobei die Signalverarbeitungseinheit (d) einen digitalen Eingang zum Abrufen externer Daten aufweist.

7. Vorrichtung nach Anspruch 6, die Signalverarbeitungseinheit (d) umfassend einen zweiten analogen Eingang (N) zum Erlangen von Frequenzschätzungsinformationen und/oder einen zweiten digitalen Ausgang, der mit einer zusätzlichen internen Speicherkapazität verbunden ist.

8. Vorrichtung nach einem der Ansprüche 1 bis 7, wobei die Analog-Digital-Wandlereinheit (a) mindestens eine Abtast- und Halteschaltung, einen Quantisierer und vorzugsweise einen digitalen Codierer umfasst, die in der Lage sind, eine Analog-Digital-Wandlung durchzuführen.

9. Vorrichtung nach einem der Ansprüche 1 bis 8, die in der Lage ist, eine Frequenzmultiplikation auszuführen und über ihren analogen Ausgang (1), der mit der Signalverarbeitungseinheit (d) gekoppelt ist, die Anfangs- und Endzeitpunkte der AD-Umwandlungsphase zu berichten, und die in der Lage ist, über ihren digitalen, vorzugsweise binären Ausgang (E), der auch mit der Signalverarbeitungseinheit (d) gekoppelt ist, den geschätzten Wert der Grundfrequenz zu berichten.

## Revendications

1. Dispositif comprenant :
un dispositif multiplicateur de fréquence (b),
une unité de conversion analogique-numérique, ADC (a), et
une unité de traitement de signal (d),
dans lequel le dispositif multiplicateur de fréquence (b) a une entrée pour un signal analogique (A) qui doit être traité, mesuré et/ou analysé, dans lequel le dispositif multiplicateur de fréquence (b) est adapté pour compter les fronts d'un signal ayant une fréquence f_{OSC}/K pendant une période du signal cible et compter les fronts d'un signal ayant une fréquence f_{OSC} pour obtenir un signal ayant un multiple de la fréquence du signal analogique (A) lors de la comparaison des deux résultats et sortir un signal dans le cas où le deux comptes sont identiques, et
l'unité ADC (a) a une entrée pour le signal analogique,
une sortie de l'unité ADC (a) est connectée à une entrée de l'unité de traitement de signal (d),
dans lequel l'unité ADC (a) et l'unité de traitement de signal (d) sont connectées et adaptées pour être accordées à la fréquence fondamentale du signal d'entrée (A) et pour effectuer le traitement, la mesure et/ou l'analyse dans l'intervalle de la période du signal d'entrée (A), dans lequel
le dispositif multiplicateur de fréquence (b) comporte au moins deux sorties (K, E) :
- dont l'une est destinée à fournir le multiple choisi de la fréquence fondamentale (II) du signal à traiter (A), dans lequel cette sortie (K) est connectée à une entrée (fs) de l'unité ADC (a), et
- dont l'une est destinée à fournir le rapport réel des fréquences (VIII) sous une forme numérique, de préférence binaire, et
l'unité ADC (a) et l'unité de traitement de signal (d) ont chacune une entrée (CLK) pour un signal d'horloge (III) ayant la fréquence f_{OSC}.

2. Dispositif selon la revendication 1, dans lequel le dispositif multiplicateur de fréquence (b) a
une sortie marche/arrêt (VII)
dans lequel la sortie marche/arrêt (VII) et la sortie (E) fournissant le rapport réel des fréquences (VIII) sont connectées aux entrées de l'unité de traitement de signal (d).

3. Dispositif selon la revendication 1 ou 2, dans lequel l'unité de conversion analogique-numérique (a) comprend en outre une sortie fournissant des valeurs numérisées du signal d'entrée.

4. Dispositif selon la revendication 3, dans lequel le dispositif comprend :
- une mémoire (c) pour stocker des valeurs numérisées du signal d'entrée reçu de l'unité de conversion analogique-numérique (a), notamment entre les phases de conversion et de traitement avec une entrée d'horloge, une entrée numérique et une sortie numérique.

5. Dispositif selon la revendication 4, dans lequel la mémoire (c) a toutes les interfaces numériques de conception parallèle.

6. Dispositif selon l'une quelconque des revendications 1 à 5, dans lequel
- l'unité de traitement de signal (d) est adaptée pour remplir la fonctionnalité de traitement principale du dispositif, l'unité de traitement de signal (d) ayant une entrée numérique pour extraire des données externes.

7. Dispositif selon la revendication 6, l'unité de traitement de signal (d) comprenant une deuxième entrée analogique (N) pour obtenir des informations d'estimation de fréquence et/ou une deuxième sortie numérique connectée à une capacité de mémoire interne supplémentaire.

8. Dispositif selon l'une quelconque des revendications 1 à 7, dans lequel l'unité de conversion analogique-numérique (a) comprend au minimum un circuit échantillonneur-bloqueur, un quantificateur et de préférence un codeur numérique, capables d'effectuer une conversion analogique-numérique.

9. Dispositif selon l'une quelconque des revendications 1 à 8, capable d'effectuer une multiplication de fréquence et de rapporter les instances de début et de fin de la phase de conversion AD par l'intermédiaire de sa sortie analogique (J) couplée à l'unité de traitement de signal (d), et capable de rapporter la valeur estimée de la fréquence fondamentale par l'intermédiaire de sa sortie numérique, de préférence binaire (E) également couplée à l'unité de traitement de signal (d).
